(19) **Europäisches Patentamt / European Patent Office / Office européen des brevets**

(11) **EP 3 373 489 B1**

(12) **FASCICULE DE BREVET EUROPEEN**

(45) Date de publication et mention de la délivrance du brevet:
**16.11.2022 Bulletin 2022/46**

(21) Numéro de dépôt: **18160381.2**

(22) Date de dépôt: **07.03.2018**

(51) Classification Internationale des Brevets (IPC):
**H04L 1/00** *(2006.01)*    **H03M 13/29** *(2006.01)*
**H04L 27/32** *(2006.01)*    **H04L 27/10** *(2006.01)*
**H04L 27/02** *(2006.01)*    **H04L 25/49** *(2006.01)*

(52) Classification Coopérative des Brevets (CPC):
**H03M 13/2957; H03M 13/258; H03M 13/2996;**
**H04L 1/0041; H04L 1/005; H04L 1/0066;**
**H04L 1/0068; H04L 1/0071; H04L 25/4902;**
**H04L 27/32;** H04L 27/02; H04L 27/10

(54) **SYSTÈME D'ÉMISSION/RÉCEPTION UTILISANT UNE MODULATION CONJOINTE ORTHOGONALE-LINÉAIRE**

SENDE-/EMPFANGSSYSTEM, DAS EINE KOMBINIERTE ORTHOGONAL-LINEARE MODULATION VERWENDET

TRANSMITTING/RECEIVING SYSTEM USING JOINT ORTHOGONAL-LINEAR MODULATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.03.2017 FR 1751927**

(43) Date de publication de la demande:
**12.09.2018 Bulletin 2018/37**

(73) Titulaire: **Commissariat à l'Energie Atomique et aux Energies Alternatives**
**75015 Paris (FR)**

(72) Inventeurs:
• **ROTH, Yoann**
  **38000 GRENOBLE (FR)**
• **BERG, Vincent**
  **38700 CORENC (FR)**
• **DORE, Jean-Baptiste**
  **38120 FONTANIL-CORNILLON (FR)**
• **ROS, Laurent**
  **38420 DOMENE (FR)**

(74) Mandataire: **Brevalex**
**56, Boulevard de l'Embouchure**
**B.P. 27519**
**31075 Toulouse Cedex 2 (FR)**

(56) Documents cités:
• **ROTH YOANN ET AL: "Turbo-FSK: A new uplink scheme for low power wide area networks", 2015 IEEE 16TH INTERNATIONAL WORKSHOP ON SIGNAL PROCESSING ADVANCES IN WIRELESS COMMUNICATIONS (SPAWC), IEEE, 28 juin 2015 (2015-06-28), pages 81-85, XP033213207, DOI: 10.1109/SPAWC.2015.7227004**
• **ALVES R ET AL: "Coding of PPM based modulation techniques to improve the performance of infrared WLANs", VEHICULAR TECHNOLOGY CONFERENCE, 2000. IEEE VTS FALL VTC 2000. 52ND SEPT. 24-28, 2000, PISCATAWAY, NJ, USA,IEEE, vol. 3, 24 septembre 2000 (2000-09-24), pages 1345-1352, XP010524715, ISBN: 978-0-7803-6507-0**
• **WANG KAIMIN ET AL: "A novel trellis coded overlapping amplitude and pulse position modulation scheme for gamma-gamma channel free-space optical communication", CHINA COMMUNICATIONS, CHINA INSTITUTE OF COMMUNICATIONS, PISCATAWAY, NJ, USA, vol. 13, no. 4, 1 avril 2016 (2016-04-01), pages 58-69, XP011611358, ISSN: 1673-5447, DOI: 10.1109/CC.2016.7464123 [extrait le 2016-05-02]**

**Description**

**DOMAINE TECHNIQUE**

La présente invention concerne de manière générale le domaine des communications machine à machine ou M2M dans le contexte de l'Internet des Objets ou IoT (*Internet of Things*) et plus particulièrement celui des communications à bas débit et contraintes en énergie.

**ÉTAT DE LA TECHNIQUE ANTÉRIEURE**

Le développement des communications M2M dans le contexte de l'Internet des objets, en particulier pour les réseaux LPWAN (*Low Power Wide Area Networks*) a stimulé la recherche d'une technologie capable de conjuguer faible consommation et faible niveau de sensibilité, de manière à respecter notamment les contraintes de consommation d'énergie au niveau des terminaux.

Les technologies envisagées actuellement pour répondre à ce cahier des charges sont de deux types.

Le premier type est constitué par les transmissions à bande très étroite permettant de minimiser la puissance de bruit à la réception et donc d'augmenter le rapport signal sur bruit dans la bande. Les systèmes de cette catégorie souffrent généralement de problèmes inhérents à la longueur des blocs de transmission, notamment la poursuite d'horloge et la compensation des variations du canal (le canal ne peut pas être considéré comme statique pendant la transmission d'un bloc).

Le second type est constitué par les systèmes capables d'opérer à de faibles niveaux de rapport signal sur bruit en utilisant des schémas de modulation et/ou de codage à faible efficacité spectrale. Les modulations orthogonales d'ordre $M$ sont bien adaptées aux communications à bas débit, contraintes en énergie. Elles permettent d'obtenir des niveaux d'efficacité énergétique (exprimée en bits/Joule) élevés qui atteignent la limite de capacité de Shannon lorsque la taille $M$ de l'alphabet tend vers l'infini. Toutefois, elles conduisent corrélativement à des niveaux d'efficacité spectrale (exprimée en bits/s/Hz) qui tendent vers zéro lorsque la taille de l'alphabet tend vers l'infini. L'utilisation d'un alphabet de grande taille conduit à des formes d'onde de durée très longue, seulement compatibles à des débits excessivement bas. Une alternative pour augmenter l'efficacité énergétique de la transmission sans réduire excessivement l'efficacité spectrale est d'utiliser un codage canal et notamment un turbocodage conjointement à une modulation orthogonale.

Un premier exemple de combinaison d'une modulation orthogonale avec un turbocode est décrit dans l'article de L. Ping et al. intitulé « Low rate turbo-Hadamard codes » publié dans IEEE Trans. on Information Theory, vol. 49, No. 12, pp. 3213-3224, Dec. 2003. La modulation utilisée est une modulation par séquences de Hadamard. Ce schéma de codage et modulation, dénommé Turbo-Hadamard, permet d'approcher la capacité de Shannon à près de 0.29 dB mais pour des blocs de taille supérieure à $10^6$ bits. Ainsi, le schéma Turbo-Hadamard n'est pas adapté aux transmissions à bas débit comme celles ayant lieu dans les réseaux LPWAN.

Un second exemple de combinaison d'une modulation orthogonale avec un turbocode est décrit dans l'article de Y. Roth et al. intitulé « Turbo-FSK : a new uplink scheme for Low Power Wide Area Network » publié dans Proc. of the IEEE 16th Int'l Workshop on Signal Processing Advances in Wireless Communications (SPAWC), Juin 2015, pp.81-85. La modulation utilisée est une modulation FSK (modulation par déplacement de fréquence) en lieu et place de la modulation par séquence de Hadamard. Le schéma correspondant est dénommé pour cette raison Turbo-FSK.

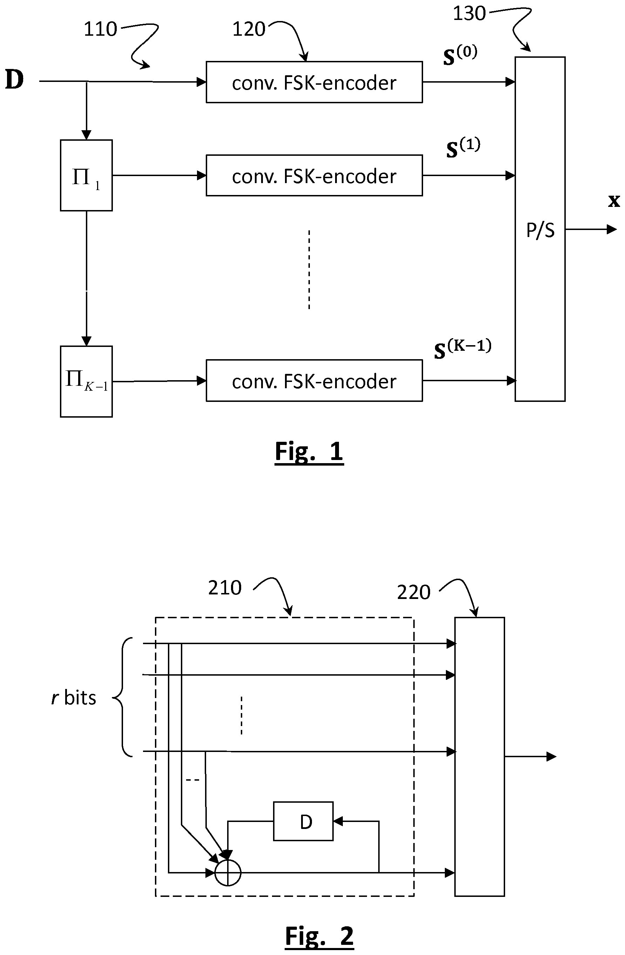

La Fig. 1 représente schématiquement la structure d'un émetteur utilisant un schéma Turbo-FSK.

L'émetteur comprend une pluralité $K$ de branches en parallèle, 110, chaque branche encodant une version entrelacée des bits d'information. Plus précisément, les bits d'information à transmettre sont groupés sous forme de blocs de taille $Q=q \times r$, autrement dit chaque bloc est composé de $q$ mots de $r$ bits, que l'on peut encore représenter par une matrice **D** de taille $q \times r$. Le bloc **D** est fourni tel quel à la première branche et est entrelacé successivement par les entrelaceurs $\Pi_1,...,\Pi_{K-1}$, chaque sortie d'un entrelaceur fournissant une version entrelacée du bloc à une branche correspondante.

Chaque branche comprend un module, 120, constitué d'un codeur convolutif systématique associé à un modulateur FSK. La structure des modules 120 est identique et a été représentée de manière schématique en Fig. 2.

Le codeur convolutif systématique (les $r$ bits d'information sont codés tels quels), 210, ajoute un bit de parité, calculé comme la somme des bits systématiques et du bit de parité du mot précédent. Le mot de code de taille $r+1$, constitué des $r$ bits systématiques et du bit de parité, est fourni au modulateur FSK, 220. Plus précisément, chaque mot de $r+1$ bits est mappé sur un symbole $S$ de l'alphabet FSK de taille $M = 2^{r+1}$. Autrement dit, à chaque mot de $r+1$ bits est associé un déplacement de fréquence parmi $M$ déplacements possibles. Les symboles de l'alphabet FSK sont par exemple les lignes d'une matrice de DFT (*Discrete Fourier Transform*) de taille $M \times M$.

Revenant à la Fig. 1, pour chaque mot du bloc, les $K$ branches 120 fournissent les symboles FSK, notés $S^{(0)},S^{(1)},...,S^{(K-1)}$ à un convertisseur parallèle/ série, 130, et le flux de symboles FSK ainsi obtenu est utilisé pour moduler une porteuse.

Etant donné qu'il est nécessaire de fermer le treillis des codeurs convolutifs avec un mot supplémentaire (pour remettre à 0 le registre d'état), l'efficacité spectrale de l'émetteur est en définitive :

$$\eta = \frac{qr}{(q+1)MK} \approx \frac{r}{K2^{r+1}} \qquad (1)$$

l'approximation étant valable pour de grandes tailles de bloc. On comprend que l'efficacité spectrale, même si elle est adaptée au réseau LPWA, reste très faible ($\eta$=1/8 pour les valeurs minimales $r$=1 et $K$ = 2). Un fonctionnement à de plus hautes efficacités spectrales peut être nécessaire selon l'application, ou dans des situations où la portée de la communication est moins contrainte.

L'article de Roth Yoann et al intitulé « Turbo-FSK : a new uplink scheme for low power wide area networks", publié dans Proc. of 2015 IEEE 16th International Workshop on Signal Processing Advances in Wireless Communications (SPAWC), 28 juin 2015, pages 81-85 décrit un émetteur utilisant un turbocodeur comprenant une pluralité de branches, chaque branche comprenant un entrelaceur suivi d'un codeur FSK convolutif élémentaire fournissant des symboles de modulation FSK.

Rui Alves et AI. "Coding of PPM based modulation techniques to improve the performance of infrared WLANs", IEEE Vehicular Technology Conference, VTC, 2000, Volume 3, pages 1345-1352, 24 Septembre 2000, propose l'utilisation d'une modulation codée en treillis avec un code convolutif et une modulation de type MxAPPM. La modulation d'amplitude et de position d'impulsion APPM comprend M symboles générés en appliquant une modulation d'amplitude à K niveaux à L formes d'ondes orthogonales. Ainsi M=KL et log2(M) bits produits par le codeur convolutif sont associés à 1 symbole de la modulation AxM-APPM.

Wang Kaimin, et AI. "A novel trellis coded overlapping amplitude and pulse position modulation scheme for gamma-gamma channel free-space optical communication", China Communications, China Institute of Communications, Volume 13, number 4, pages 58-69, 01 Avril 2016, passe en revue les modulations codées pour les systèmes de communication optique utilisant de multiples techniques de codage possibles, telles que le codage convolutif, et de multiples techniques de modulations, telles que les modulations AxM-APPM.

Le but de la présente invention est par conséquent de proposer un système d'émission/réception pour réseau LPWA qui permette d'atteindre des débits plus importants que ceux de l'art antérieur tout en présentant une efficacité spectrale élevée. Un but subsidiaire de la présente invention est de pouvoir offrir de la flexibilité entre efficacité énergétique et efficacité spectrale pour une transmission dans un réseau LPWA.

## EXPOSÉ DE L'INVENTION

La présente invention est définie par un émetteur tel que revendiqué dans la revendication 1.

L'invention concerne également un récepteur, destiné à recevoir un signal émis par ledit émetteur, tel que revendiqué dans la revendication 7. Des modes de réalisation avantageux sont précisés dans les revendications dépendantes.

## BRÈVE DESCRIPTION DES DESSINS

La Fig. 1 représente de manière schématique la structure d'un émetteur Turbo-FSK connu de l'état de la technique ;
La Fig. 2 représente de manière schématique le détail d'un module de l'émetteur de la Fig. 1 ;
La Fig. 3 représente un exemple d'alphabet de modulation conjointe ;
La Fig. 4 représente de manière schématique la structure d'un émetteur selon un mode de réalisation de l'invention ;
La Fig. 5 représente de manière schématique le détail d'un module de l'émetteur de la Fig. 4 ;
La Fig. 6 représente un exemple de schéma de poinçonnage utilisé dans l'émetteur de la Fig. 4 ;
La Fig. 7 représente de manière schématique la structure d'un récepteur selon un mode de réalisation de l'invention ;
La Fig. 8 représente de manière schématique le détail d'une branche du récepteur de la Fig. 7 ;
La Fig. 9 représente un exemple du treillis de codage utilisé par un décodeur élémentaire dans la branche du récepteur de la Fig. 8 ;
La Fig. 10 donne l'efficacité spectrale en fonction du rapport signal sur bruit pour un système de transmission utilisant un émetteur et un récepteur selon un exemple de réalisation de l'invention ;
La Fig. 11 représente la courbe de taux d'erreur paquet en fonction du rapport signal sur bruit pour un système de transmission utilisant un émetteur et un récepteur selon un exemple de réalisation de l'invention.

## EXPOSÉ DÉTAILLÉ DE MODES DE RÉALISATION PARTICULIERS

L'idée à la base de la présente invention est de faire appel à une modulation conjointe (ou hybride), c'est-à-dire à la fois linéaire et orthogonale. De manière générale, une opération de modulation consiste à associer à un mot binaire un symbole de modulation constitué d'un symbole complexe ou d'une séquence de symboles complexes.

L'ensemble des symboles de modulation est appelé alphabet de modulation. Un alphabet de modulation $\mathcal{A}$ de taille $M$ permet de représenter jusqu'à $\lfloor \log_2(M) \rfloor$ mots binaires distincts.

L'alphabet $\mathcal{A}$ est dit orthogonal si :

$$\forall a_i \in \mathcal{A}, \forall a_j \in \mathcal{A}, \text{ on a } \langle a_i | a_j \rangle = M \text{ si } i = j \text{ et } \langle a_i | a_j \rangle = 0 \text{ si } i \neq j$$

$$(2)$$

où $\langle . | . \rangle$ est un produit scalaire. Lorsqu'une modulation utilise un alphabet orthogonal, la modulation est dite orthogonale. Des exemples de modulation orthogonale sont la modulation par séquences de Hadamard, la modulation FSK, la modulation PPM (*Pulse Position Modulation*). Dans le premier cas, l'alphabet $\mathcal{A}$ est constitué par les lignes d'une matrice de Hadamard, dans le second par les lignes d'une matrice de Fourier discrète (DFT) et dans le dernier cas, par exemple, par l'ensemble $\{\delta(t-mT); m = 0,...,M\text{-}1\}$ où $\delta(.)$ est la distribution de Dirac et $T$ l'intervalle temporel entre positions de modulation successives.

En pratique, lorsqu'un symbole d'un alphabet orthogonal est transmis par l'émetteur, la démodulation peut être effectuée (démodulation non-cohérente) en projetant le signal modulé reçu sur les différents symboles de l'alphabet, autrement dit en calculant le produit scalaire du symbole reçu avec les différents symboles de l'alphabet. Le produit scalaire le plus élevé en valeur absolue fournit alors le symbole de modulation le plus probable.

L'alphabet $\mathcal{A}$ est dit linéaire si les symboles de modulation sont tous des multiples d'un symbole de $\mathcal{A}$ par un coefficient complexe. Lorsqu'une modulation utilise un alphabet linéaire, la modulation sera dite linéaire. Des exemples de modulation linéaire sont la modulation par déplacement d'amplitude ou ASK (*Amplitude Shift Keying*) ou encore la modulation par déplacement de phase ou PSK (*Phase Shift Keying*).

Les modulations orthogonales et les modulations linéaires se comportent de manière opposée en termes d'efficacité spectrale et d'efficacité énergétique. En effet, pour une modulation linéaire, l'efficacité spectrale augmente et l'efficacité énergétique décroit avec la taille $M$ de l'alphabet. A l'inverse, pour une modulation orthogonale, l'efficacité spectrale décroit et l'efficacité énergétique augmente jusqu'à un maximum dépendant de la densité spectrale de bruit.

La présente invention propose d'utiliser un alphabet de modulation dont seuls certains symboles sont orthogonaux. Plus précisément, l'alphabet $\mathcal{A}$ se répartit sur $N$ dimensions orthogonales, le groupe des symboles porté par une dimension $n$ constituant un sous-alphabet noté $\mathcal{A}_n$ de cardinal $P$. On a par conséquent la relation $M = N \times P$.

Les symboles de l'alphabet $\mathcal{A}$ vérifient :

$$\langle a_i | a_j \rangle = N\alpha_{i-j} \text{ si } \exists n \in \{0,...,N-1\} \text{ tel que } a_i, a_j \in \mathcal{A}_n$$

$$\langle a_i | a_j \rangle = 0 \quad \text{sinon} \qquad (3)$$

où $\alpha_{i-j}$ est un nombre complexe représentant l'écart entre deux symboles $\alpha_i$ et $\alpha_j$ appartenant à un même sous-alphabet (même dimension $n$). Autrement dit, deux symboles appartenant à des sous-alphabets $\mathcal{A}_n$ distincts sont orthogonaux entre eux alors que deux symboles appartenant à un même sous-alphabet sont multiples l'un de l'autre par un coefficient complexe.

Une modulation utilisant un alphabet vérifiant la condition (3) est dénommée modulation conjointe (ou hybride). Elle possède les propriétés d'une modulation linéaire au sein d'une même dimension et les propriétés d'une modulation orthogonale entre les différentes dimensions orthogonales.

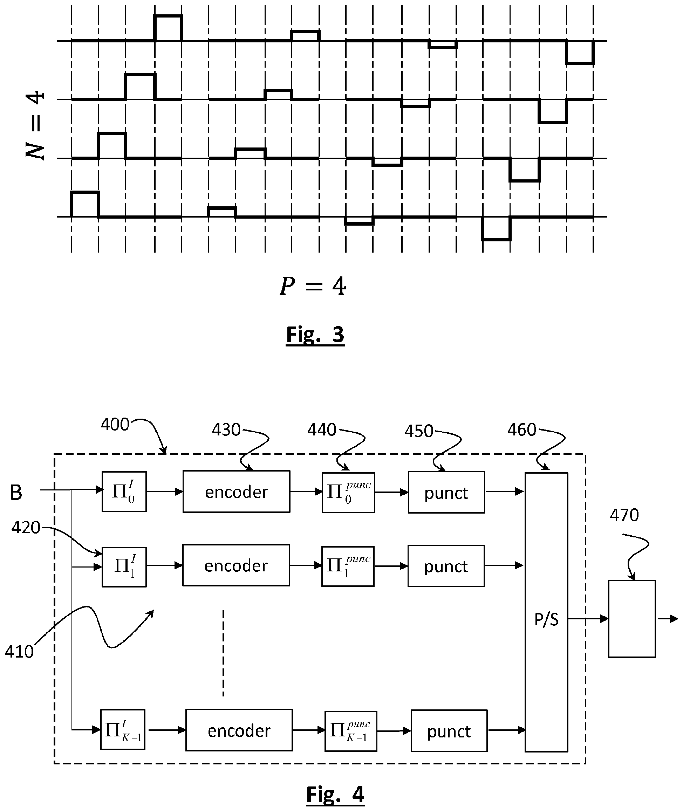

La Fig. 3 représente un exemple de modulation conjointe avec $N = 4$ et $P = 4$. Autrement dit, l'alphabet comporte 4 dimensions orthogonales, ici 4 positions temporelles d'une modulation 4-PPM (modulation orthogonale : *Pulse Position Modulation*), et 4 symboles par dimension correspondant aux 4 niveaux d'une modulation 4-ASK ou 4-PAM (modulation linéaire : *Pulse Amplitude Modulation*). L'alphabet complet comporte donc 16 symboles, chaque symbole correspondant à une position temporelle (relation orthogonale) et un niveau d'amplitude (relation linéaire). On note sur la Fig. 3 que les sous-alphabets $\mathcal{A}_n$ sont constitués par les symboles portés par une même ligne et que les dimensions orthogonales sont les différentes lignes.

Une modulation conjointe à $N$ dimensions orthogonales et $P$ symboles de modulation par dimension orthogonale correspond à une efficacité spectrale :

$$\eta = \frac{\log_2(M)}{N} = \frac{\log_2(N) + \log_2(P)}{N} \tag{4}$$

qui est supérieure à l'efficacité spectrale d'une modulation orthogonale seule en raison de la présence du terme $\log_2(P)$. Toutefois, la présence de symboles de modulation non-orthogonaux conduit à une augmentation importante du taux d'erreur binaire pour un même rapport signal sur bruit.

La Fig. 4 représente schématiquement la structure d'un émetteur selon un mode de réalisation de l'invention.

L'émetteur comprend un turbocodeur 400 suivi d'un modulateur 470 mappant les mots de code sur des symboles de modulation conjointe.

Le turbocodeur comprend une pluralité $K$ de branches en parallèle, 410, chaque branche encodant une version entrelacée des bits d'information. Les bits d'information à transmettre sont groupés sous forme de blocs **B** de taille $Q = q \times r$, le cas échéant après avoir été complétés par des bits de bourrage (par exemple *zero padding*). Chaque bloc est entrelacé (au niveau bit) par les entrelaceurs $\Pi_0^I, ..., \Pi_{K-1}^I$, désignés par 420 et situés respectivement à l'entrée de chacune des $K$ branches 410.

Les $K$ branches 410 ayant toutes la même structure, il suffira de décrire une branche d'indice $\ell = 0, ..., K-1$. Cette branche comprend un entrelaceur effectuant un entrelacement des bits sur les blocs de taille $Q = q \times r$. Chaque mot de $r$ bits en sortie de l'entrelaceur fait ensuite l'objet d'un codage convolutif. Plus précisément, le flux de bits en sortie de l'entrelaceur $\Pi_\ell^I$ est fourni à un codeur élémentaire, 430.

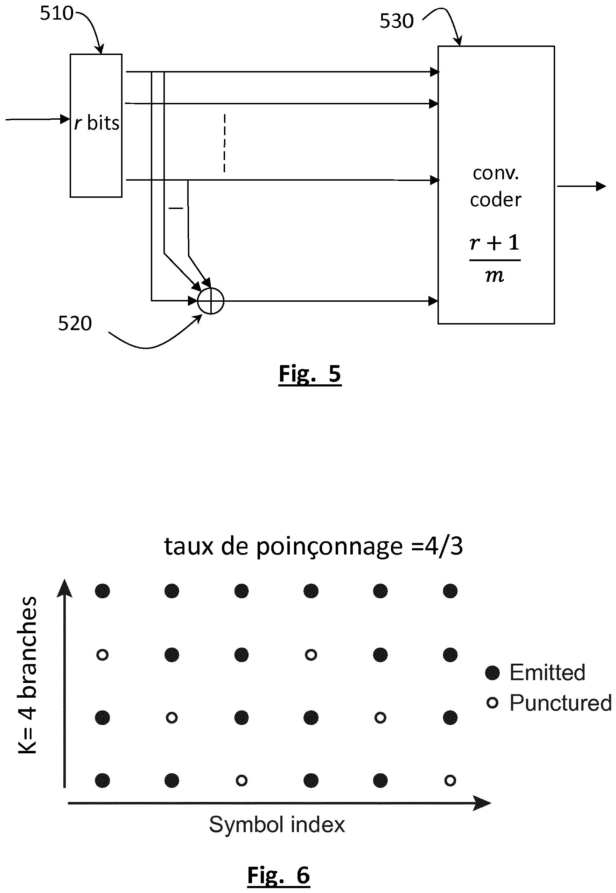

La structure du codeur élémentaire 430 est représentée schématiquement en Fig. 5.

Les bits en entrée du codeur élémentaire (issus de l'entrelacement d'un bloc) sont groupés sous la forme de mots de taille $r$ en 510. Pour chaque mot, un bit de parité est calculé en sommant en 520 les $r$ bits d'information. Le mot de taille $r+1$ résultant de la concaténation du mot d'entrée et du bit de parité ainsi calculé est fourni à un codeur convolutif, 530, de rendement $\frac{r+1}{m}$. Autrement dit, pour chaque mot de taille $r+1$ en entrée du codeur convolutif, celui-ci fournit en sortie un mot de code de taille $m$. Le rendement total du codeur élémentaire est par conséquent $\frac{r}{m}$. Le codeur élémentaire peut être systématique ou non. Lorsque celui-ci est systématique, le mot de code en sortie du codeur est composé des $r$ bits d'information du mot d'entrée et $c = m - r$ bits de parité.

Le codeur convolutif est classiquement constitué d'un registre à décalage à $L$ emplacements mémoire et d'une logique combinatoire. Pour remettre à zéro le registre et fermer le treillis de codage, une pluralité $L$ de mots de $m$ bits calculés en fonction de l'état des mémoires après encodage des $q$ mots est insérée en fin de bloc. Ainsi, en définitive, un bloc de $q \times r$ bits est transformé par le codeur élémentaire en un bloc de $(q+L)m$ bits. Le rendement du code est par conséquent de :

$$R_c = \frac{qr}{(q+L)m} \tag{5}$$

Les mots de code (de taille $m$) en sortie du codeur élémentaire 430 sont le cas échéant entrelacés en 440, l'entrelacement se faisant au niveau des mots (et non au niveau des bits au sein d'un mot). Les entrelaceurs mot sont dénommés $\Pi_0^{punc}, ..., \Pi_{K-1}^{punc}$.

Les mots de code en sortie du codeur élémentaire, 430, ou de l'entrelaceur mot, 440, si celui-ci est présent, sont ensuite poinçonnés en 450. Le poinçonnage se fait ici sur des mots entiers (et non sur des bits), autrement dit les poinçonneurs 450 sont des poinçonneurs mot. Le taux de poinçonnage représente le rapport entre le nombre de mots de code en entrée et le nombre de mots de code en sortie du poinçonneur. Il est noté dans la suite $R_{punc}$ avec $R_{punc} > 1$.

La Fig. 6 représente un exemple de schéma de poinçonnage utilisé pour les différentes branches de l'émetteur. Les lignes correspondent ici aux différentes branches de l'émetteur ($K$ lignes) et les colonnes correspondent aux mots successifs. Les schémas d'entrelacement et de poinçonnage sont choisis de manière à ce que les bits systématiques (les $q \times r$ bits d'information du bloc) soient présents au moins une fois en sortie de l'une des branches.

Les $K$ flux de mots en sortie des poinçonneurs 450 des différentes branches sont convertis en flux unique de mots de code au moyen d'un convertisseur parallèle série, 460.

Les mots de code successifs en sortie du convertisseur parallèle série 460 sont ensuite mappés par le modulateur 470 sur des symboles de modulation d'un alphabet de modulation conjointe au sens défini précédemment.

L'alphabet de modulation est de taille $M = 2^m$ avec $M = N \times P$ où $N$ est le nombre de dimensions orthogonales et $P$ le nombre de symboles par sous-alphabet $\mathscr{A}_n$ .

L'efficacité spectrale est alors donnée par :

$$\eta = \frac{qr}{(q+L)m} R_{punc} \frac{m}{N} \frac{1}{K} = \frac{qr}{(q+L)NK} R_{punc} \approx \frac{r}{NK} R_{punc} \qquad (6)$$

l'approximation étant valable pour de grandes tailles $Q$ de bloc. Dans la mesure où le nombre $N$ de dimensions orthogonales est sensiblement inférieur à $2^r$, l'efficacité spectrale est supérieure à celle donnée par l'expression (1) en raison de la contribution apportée par la modulation linéaire. En outre, la dégradation des performances en termes de BER (*Bit Error Rate*) ou de PER (*Packet Error Rate*) en fonction du rapport signal sur bruit, due à la modulation linéaire, est compensée par l'utilisation d'un turbocodage.

Pour réaliser la modulation conjointe, on pourra par exemple combiner une modulation par séquences de Hadamard (modulation orthogonale) et une modulation PSK (modulation linéaire). Selon une première variante, on pourra combiner une modulation FSK (modulation orthogonale) et une modulation PSK (modulation linéaire). Selon une seconde variante, on pourra combiner une modulation FSK (modulation orthogonale) avec une modulation APSK (*Amplitude Phase Shift Keying*) (modulation linéaire).

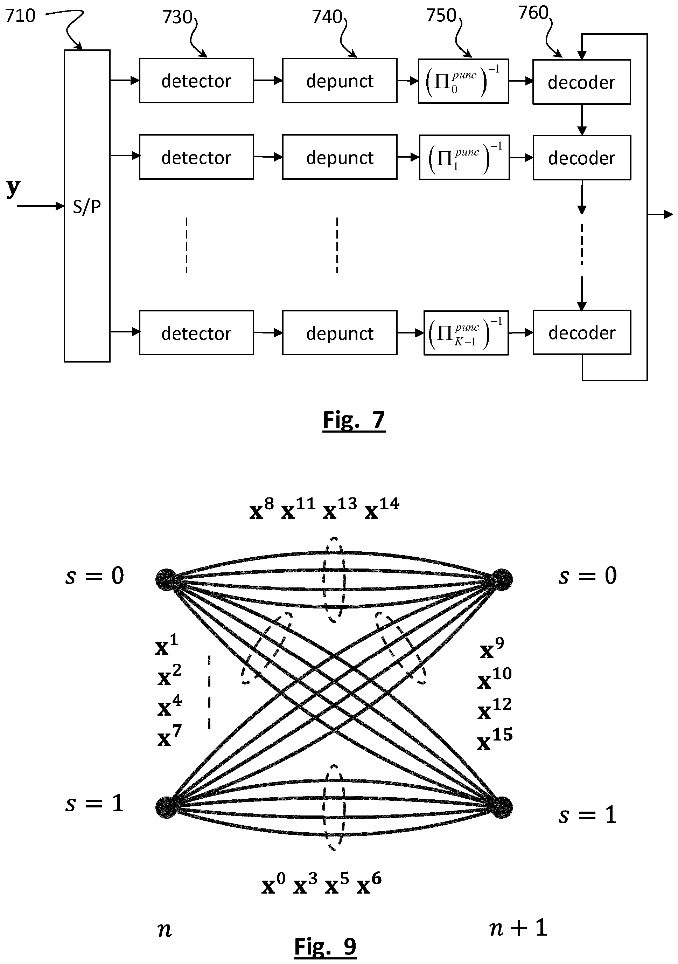

La Fig. 7 représente de manière schématique la structure d'un récepteur selon un mode de réalisation de l'invention.

On rappelle préalablement qu'un symbole de modulation conjointe émis par l'émetteur 400 peut être représenté par un vecteur $x^k$ avec $k \in \{0,...,NP\text{-}1\}$ de dimension $N$ :

$$\mathbf{x}^k = z_p \mathbf{f}^n \qquad (7)$$

où $k = nP + p$ et $\mathbf{f}^n = \left( f_0^n, f_1^n, ..., f_{N-1}^n \right)^T$ est un vecteur de taille $N$ représentant un symbole de l'alphabet orthogonal et $z_p \in \mathbb{C}$ est un coefficient complexe.

Si l'on suppose que le symbole de modulation conjointe est émis sur un canal additif blanc gaussien, le signal correspondant reçu, après démodulation en bande de base, peut être représenté par un vecteur :

$$\mathbf{y} = \mathbf{x}^k + \chi \qquad (8)$$

où $\chi$ est un vecteur dont les composantes complexes sont des variables i.i.d circulaires complexes, de moyenne nulle et de variance égale à $\sigma^2$. Le symbole y peut être considéré (au même titre $x^k$ ) comme un vecteur de taille $N$ dans l'espace sous-tendu par les $N$ dimensions orthogonales de l'alphabet de modulation. Il représente un symbole de modulation conjointe, bruité par le canal.

Les symboles **y** successifs sont fournis à un convertisseur série parallèle 710 à $K$ sorties reliées à $K$ branches de traitement en parallèle, 720. Ces $K$ branches correspondent aux $K$ branches 410 de l'émetteur, chaque branche $\ell$ recevant un symbole noté $\mathbf{y}^\ell$.

Chaque branche $\ell$ comprend un module de détection 730 suivi d'un module de dépoinçonnage 740, d'un module de désentrelacement optionnel, 750, et d'un décodeur élémentaire, 760. Les décodeurs élémentaires des différentes branches sont chainés entre eux de manière à réaliser un turbodécodage. Plus précisément, le décodeur élémentaire d'une branche d'indice $\ell=1,...,K\text{-}1$ reçoit du décodeur élémentaire de la branche d'indice $\ell\text{-}1$, une information

*a priori* relative aux bits d'information d'un bloc (de taille $Q=qr$) et fournit au décodeur élémentaire de la branche d'indice $\ell+1$, une information *a posteriori* sur ces bits d'informaton. Le décodeur élémentaire de la première branche (branche d'indice 0) reçoit l'information *a priori* du décodeur élémentaire de la dernière branche (branche d'indice $K$ -1 ) et fournit une information *a posteriori* au décodeur élémentaire de la branche d'indice 1.

Le turbodécodage est réalisé par une pluralité d'itérations sur un bloc, chaque itération comprenant une séquence d'opérations de décodage par les décodeurs élémentaires des différentes branches du récepteur. Lorsqu'un critère d'arrêt est satisfait (par exemple lorsqu'un nombre maximal d'itérations est atteint, lorsque l'information *a posteriori* relative aux bits du bloc est supérieure en valeur absolue à un seuil prédéterminé ou bien lorsque le CRC est vérifié), le turbodécodage cesse et les valeurs souples obtenues sont fournies à un module de décision (non représenté) donnant une estimation des bits d'information du bloc considéré.

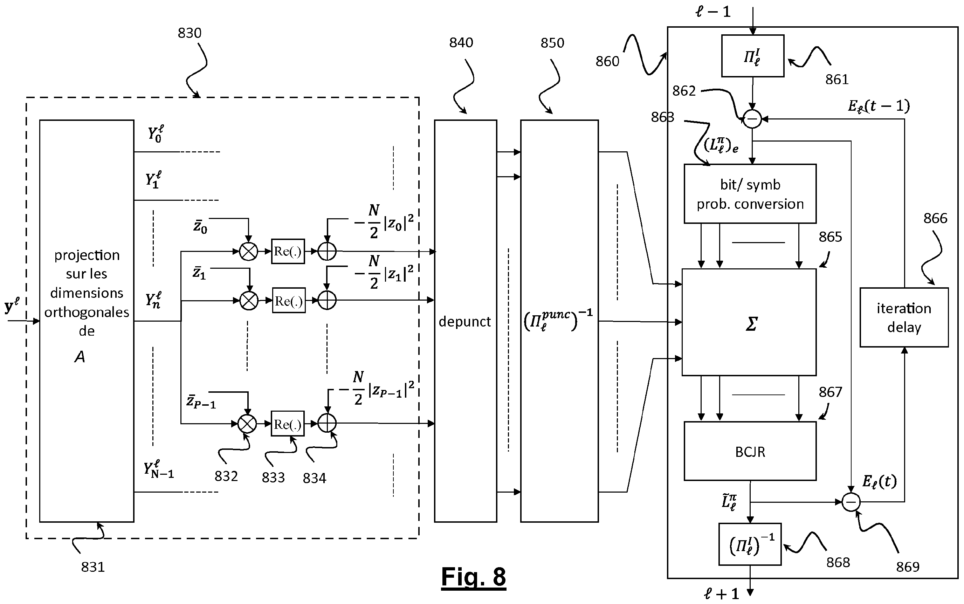

La Fig. 8 représente de manière schématique le détail d'une branche du récepteur de la Fig. 7.

On considère tout d'abord un symbole **y** correspondant à un symbole de modulation bruité par le canal comme exprimé en (8). Comme indiqué plus haut, le symbole **y** peut être considéré comme un vecteur de taille $N$ dans l'espace sous-tendu par les dimensions orthogonales de l'alphabet.

La probabilité d'observer la composante $y_i$ de **y** en sortie du canal alors que la composante orthogonale $x_i^k$ du symbole de modulation conjointe $x^k$ a été émise s'exprime par la vraisemblance:

$$p\left(y_i\left|x_i^k\right.\right) = \frac{1}{2\pi\sigma^2}\exp\left\{-\frac{1}{2\sigma^2}\left|y_i - x_i^k\right|^2\right\} =$$
$$= \frac{1}{2\pi\sigma^2}\exp\left\{-\frac{\left|y_i\right|^2}{2\sigma^2}\right\}\exp\left\{-\frac{\left|x_i^k\right|^2}{2\sigma^2} + \frac{1}{\sigma^2}\left\langle y_i, x_i^k\right\rangle\right\} \qquad (9)$$

où $\left\langle y_i, x_i^k\right\rangle = \mathrm{Re}\left(y_i\overline{x}_i^k\right)$.

La vraisemblance du vecteur **y** à la réception sachant que le symbole de modulation conjointe $x^k$ a été émis n'est autre que le produit des vraisemblances de ses composantes :

$$p\left(\mathbf{y}\left|\mathbf{x}^k\right.\right) = \prod_{i=0}^{N-1} p\left(y_i\left|x_i^k\right.\right) \qquad (10)$$

Compte-tenu de l'expression (9) et en exploitant la construction de l'alphabet de modulation conjointe :

$$\sum_{i=0}^{N-1}\left|x_i^k\right|^2 = \left|z_p\right|^2\sum_{i=0}^{N-1}\left|f_i^n\right|^2 = N\left|z_p\right|^2 \qquad (11)$$

cette vraisemblance peut encore s'écrire sous la forme:

$$p\left(\mathbf{y}\left|\mathbf{x}^k\right.\right) = C\exp\left\{-\frac{N}{2\sigma^2}\left|z_p\right|^2 + \frac{1}{\sigma^2}\left\langle Y_n, z_p\right\rangle\right\} \qquad (12)$$

où C est une constante et $Y_n = \sum_{i=0}^{N-1} y_i\overline{f}_i^n$ est la projection du vecteur **y** sur la $n$ième dimension de l'alphabet.

On considère maintenant un symbole de modulation bruité, $\mathbf{y}^\ell$, fourni (par le convertisseur série parallèle 710) à la branche d'indice $\ell$ , plus précisément au module de détection 830 de cette branche. Le vecteur $\mathbf{y}^\ell$ est tout d'abord projeté dans le module de corrélation 831 sur les $N$ directions orthogonales de l'alphabet pour fournir $N$ composantes

orthogonales, $Y_n^\ell$, n=0,...,N-1, soit $Y_n^\ell = \sum_{i=0}^{N-1} y_i^\ell \overline{f_i^n}$ où $y_i^\ell$, i=0,..,N-1 sont les composantes du vecteur $\mathbf{y}^\ell$. On comprendra que cette projection est effectuée par corrélation du vecteur reçu $\mathbf{y}^\ell$ avec les différents symboles de modulation orthogonale $f^n$, n=0,...,N-1. Ainsi par exemple, si la modulation orthogonale est une modulation FSK, les différentes projections orthogonales seront obtenues en corrélant le signal reçu avec les sinusoïdes aux différentes fréquences FSK (autrement dit avec les différentes lignes de la matrice DFT).

On calcule ensuite dans le module 830 le logarithme des vraisemblances de $\mathbf{y}^\ell$ pour les différents symboles de modulation de l'alphabet, $x^k$, $k \in \{0,...,NP\text{-}1\}$ soit, d'après l'expression (12), $-\frac{N}{2}\left|z_p\right|^2 + \mathrm{Re}\left(Y_n^\ell \overline{z_p}\right)$ au facteur commun $\frac{1}{\sigma^2}$ près, pour $n = 0,...,N\text{-}1$ et $p = 0,...,P\text{-}1$.

Pour ce faire, chaque composante orthogonale $Y_n^\ell$, $n = 0,...,N\text{-}1$, est multipliée par $\overline{z_p}$, $p = 0,...,P\text{-}1$, en 832, la valeur réelle en est extraite en 833 et le terme $-\frac{N}{2}\left|z_p\right|^2$ en est soustrait en 834.

On comprend par conséquent que le module de détection 830 fournit en définitive, pour chaque vecteur $\mathbf{y}^\ell$, un mot de NP valeurs souples $\log[p(\mathbf{y}^\ell|\mathbf{x}^k)$, $k \in \{0,...,NP\text{-}1\}$ au module de dépoinçonnage 840.

Le module de dépoinçonnage 840 insère pour chaque mot poinçonné en 450 au niveau de l'émetteur (autrement dit pour chaque symbole de modulation poinçonné), un mot de NP valeurs souples arbitraires, de préférence toutes égales à une valeur prédéterminée -log(NP), correspondant à une distribution uniforme de vraisemblance p(y$^\ell$|x$^k$).

Ainsi, le module de dépoinçonnage 840 reçoit, pour chaque bloc transmis par l'émetteur, $(q+L)/R_{punc}$ mots de NP valeurs souples et insère $(q+L)\left(1 - \dfrac{1}{R_{punc}}\right)$ mots supplémentaires à valeurs souples arbitraires pour obtenir fournir un bloc q+L mots au module de désentrelacement optionnel 850.

Le module 850 effectue un désentrelacement inverse de l'entrelacement effectué en 440 (si celui-ci est présent). Autrement dit, le module 850 de la branche $\ell$ effectue l'opération de désentrelacement $\left(\Pi_\ell^{punc}\right)^{-1}$ si un entrelacement mot a été effectué au niveau de l'émetteur.

Le bloc de q+L mots ainsi désentrelacé est fourni au décodeur élémentaire, 860. Plus précisément, on comprendra que les mots sont fournis les uns après les autres au fur et à mesure de la réception des vecteurs $\mathbf{y}^\ell$, l'opération de décodage élémentaire n'intervenant que lorsque les q+L mots ont été reçus par le décodeur.

On rappelle que chaque symbole de modulation conjointe x$^k$ est associé à un mot constitué de r bits d'information, soit $\mathbf{b}^k = \left(b_v^k\right)_{v \in \{0,...,r-1\}}$.

La fonction du décodeur élémentaire 860 est de fournir une estimation des probabilités a posteriori (avec la connaissance de l'ensemble des observations) des bits d'information du bloc transmis. Cette estimation est réalisée, de manière classique, au moyen de valeurs souples exprimées sous la forme de rapports logarithmiques de probabilité ou LR *(Log Ratio)*, soit :

$$L(b_v^k) = \log \frac{\mathrm{Pr}\left(b_v^k = +1\right)}{\mathrm{Pr}\left(b_v^k = -1\right)} \tag{13}$$

où $\mathrm{Pr}\left(b_v^k = +1\right)$, resp. $\mathrm{Pr}\left(b_v^k = -1\right)$ est la probabilité que le bit $b_v^k$ est égal à 0, (resp. égal à 1), avec la convention de représentation 0 → +1 et 1 → -1.

On rappelle que le signe (décision dure) de la valeur de LR donne l'estimation du bit et que la valeur absolue du LR indique le degré de confiance de cette estimation.

Le décodeur élémentaire calcule les valeurs de LR des bits du bloc, à partir des valeurs de LR fournies par le décodeur élémentaire précédent (c'est-à-dire de la branche $\ell$-1) et les vraisemblances calculées par le module de détection 830 (après dépoinçonnage et désentrelacement mot).

La probabilité *a posteriori* ou APP *(A Posteriori Probability)* que le symbole $x^k$ ait été émis par l'émetteur sachant que $\mathbf{y}^\ell$ a été observé par le récepteur s'exprime à partir de la probabilité *a priori* $\Pr(\mathbf{x}^k)$ :

$$\Pr\left(\mathbf{x}^k\middle|\mathbf{y}^\ell\right) = \frac{p\left(\mathbf{y}^\ell\middle|\mathbf{x}^k\right)\Pr\left(\mathbf{x}^k\right)}{\Pr\left(\mathbf{y}^\ell\right)} \tag{14}$$

Par ailleurs la probabilité *a priori* $\Pr(\mathbf{x}^k)$ n'est autre que le produit des probabilités des bits $\left(b_v^k\right)_{v\in\{0,\ldots,r-1\}}$ du mot de *r* bits auquel est associé le symbole de modulation conjointe $\mathbf{x}^k$, autrement dit :

$$\Pr\left(\mathbf{x}^k\right) = \prod_{v=0}^{r-1}\Pr\left(b_v^k\right) \tag{15}$$

On peut montrer, d'après l'expression (13) que :

$$\Pr\left(b_v^k\right) = \beta_v \exp\left(L(b_v^k)b_v^k/2\right) \tag{16}$$

où $\beta_v$ ne dépend pas du signe de $b_v^k$. Compte tenu de (14) et (16) :

$$\Pr\left(\mathbf{x}^k\right) = \left(\prod_{v=0}^{r-1}\beta_v\right).\exp\left(\frac{1}{2}\sum_{v=0}^{r-1}L(b_v^k)b_v^k\right) \tag{17}$$

Le premier terme ne dépendant pas de *k,* on peut ne pas en tenir compte dans l'estimation des $\Pr(\mathbf{x}^k)$. En définitive, la valeur d'APP du symbole de modulation $\mathbf{x}^k$ se déduit de (14), (12) et (17) :

$$\Pr\left(\mathbf{x}^k\middle|\mathbf{y}^\ell\right) = C'\exp\left(-\frac{N}{2\sigma^2}\left|z_p\right|^2 + \frac{1}{\sigma^2}\mathrm{Re}\left(Y_n^\ell\overline{z}_p\right) + \frac{1}{2}\sum_{v=0}^{r-1}L(b_v^k)b_v^k\right) \tag{18}$$

où *C'* est une constante indépendante de *k.*

Le bloc de sommation 865 effectue la somme du terme de vraisemblance $-\frac{N}{2}\left|z_p\right|^2 + \mathrm{Re}\left(Y_n^\ell\overline{z}_p\right)$ reçu du module de désentrelacement 850 et d'un terme de probabilité *a priori* (représenté par $\frac{1}{2}\sum_{v=0}^{r-1}L(b_v^k)b_v^k$ dans l'expression (18)) pour estimer une probabilité *a posteriori* ou APP, $\Pr(\mathbf{x}^k|\mathbf{y}^\ell)$. On notera que le terme de vraisemblance n'est calculé qu'une seule fois pour toutes. Le terme d'information *a priori* d'une branche $\ell$ est en fait fourni par la branche d'indice $\ell$-1 comme décrit plus loin.

Les valeurs APP sont mises à jour en tenant compte des contraintes induites par le treillis de codage. L'algorithme BCJR (encore dénommé algorithme *forward backward*) permet de mettre à jour les valeurs APP à partir de la connaissance du treillis de codage. Alternativement, on pourra utiliser des variantes simplifiées de cet algorithme telles que l'algorithme SOVA *(Soft Output Viterbi Algorithm),* l'algorithme max-log-MAP ou l'algorithme log-MAP bien connus de l'état de la technique.

On représente dans la suite la séquence des vecteurs successifs $\mathbf{y}^{\ell}$ correspondant à un bloc par $\mathbf{y} = \mathbf{y}_0,...,\mathbf{y}_{q+L-1}$ et l'on note :

$$L(\hat{b}_v^k) = \log \frac{\Pr\left(b_v^k = +1 \middle| \mathbf{y}\right)}{\Pr\left(b_v^k = -1 \middle| \mathbf{y}\right)} \qquad (19)$$

le rapport logarithmique des probabilités *a posteriori* du bit $b_v^k$ (sachant que la séquence $\mathbf{y}$ de vecteurs correspondant à un bloc ont été reçus).

On a la relation :

$$L(\hat{b}_v^k) = \log \frac{\sum_{R_{+1}} p(s,s',\mathbf{y})}{\sum_{R_{-1}} p(s,s',\mathbf{y})} = \log \frac{\sum_{R_{+1}} \alpha_{n-1}(s')\gamma_n\left(s,s'\right)\beta_n(s)}{\sum_{R_{-1}} \alpha_{n-1}(s')\gamma_n\left(s,s'\right)\beta_n(s)} \qquad (20)$$

où $R_{+1}$ (resp. $R_{-1}$) représente l'ensemble des branches dans le treillis de codage correspondant à $b_v^k = +1$ (resp. $b_v^k = -1$ ), $\alpha_{\ell-1}$(s') = $p(s'|\mathbf{y}_0,..,\mathbf{y}_{n-1})$ est la probabilité de l'état s', sachant que les vecteurs reçus ont été $\mathbf{y}_0,..,\mathbf{y}_{n-1}$, $\gamma_n(s,s')$ = $p(\mathbf{y}_n,s|s')$ est la probabilité de transition entre les états s et s' à l'instant n connaissant $\mathbf{y}_n$, et $\beta_{\ell}(s) = p(y_{n+1},...,y_{q+L-1}|s')$ est la probabilité d'observer les vecteurs $\mathbf{y}_{n+1},...,\mathbf{y}_{q+L-1}$ sachant qu'à l'instant n le codeur était dans l'état s'.

On a représenté en Fig. 9 un exemple du treillis utilisé par un décodeur élémentaire dans la branche du récepteur de la Fig. 8.

Dans cet exemple, la longueur du registre à décalage du codeur convolutif est *L*=1 (un seul emplacement mémoire) et la taille de l'alphabet *M*=16. L'état *s*=0 correspond à un contenu du registre égal à 0 et l'état s = 1 correspond à un contenu du registre égal à 1. On a représenté sur les états possibles du codeur élémentaire en deux instants successifs *n* et *n+1*. Les transitions entre les états ont été étiquetées par les symboles de modulation conjointe x$^k$ émis par le modulateur 470, c'est-à-dire les mots de taille m en sortie du codeur élémentaire. On notera que les codeurs élémentaires 430 étant identiques, les treillis utilisés par les décodeurs élémentaires 860 sont également identiques.

Les rapports logarithmiques de probabilité *a posteriori* de la branche $\ell$-1 constituent une information *a posteriori* sur les bits pour la branche $\ell$-1. Cette information *a posteriori* est utilisée comme information *a priori* par la branche suivante $\ell$ . L'information *a priori,* notée $L_{\ell}$, est entrelacée au moyen du module d'entrelacement $\Pi_{\ell}^I$ , 861, de manière à présenter les valeurs de LR, $L(\hat{b}_v^k)$ , dans l'ordre des bits d'information à l'entrée du codeur élémentaire correspondant. On note $L_{\ell}^{\pi}$ information *a priori* après entrelacement.

L'information *a priori* $L_{\ell}^{\pi}$ est ensuite débarrassée en 862 de la contribution de la branche $\ell$ (appelée information extrinsèque) obtenue à l'itération précédente, soit :

$$\left(L_{\ell}^{\pi}\right)_e = L_{\ell}^{\pi} - E_{\ell}(t-1) \qquad (21)$$

où *t* est l'indice de l'itération et $E_{\ell}(t$-1) est l'information extrinsèque obtenue à l'itération *t*-1.

Le module de conversion 863 calcule les probabilités *a priori* Pr(x$^k$) des différents symboles de modulation conjointe à partir de l'information *a priori* sur les bits $\left(L_{\ell}^{\pi}\right)_e$ . Plus précisément, il calcule le terme de probabilité *a priori* $\frac{1}{2}\sum_{v=0}^{r-1} L(\hat{b}_v^k)\hat{b}_v^k$ des expressions (17) et (18) à partir des valeurs de LR, $L(\hat{b}_v^k)$ .

Le module de sommation 865 calcule la somme du terme de vraisemblance et du terme de probabilité *a priori* et fournit les valeurs APP, Pr($\mathbf{x}^k|\mathbf{y}^\ell$) au module de décodage BCJR, 867.

Le module de décodage BCJR 867 donne des valeurs LLR, $L(\hat{b}_v^k)$ mises à jour en tenant compte des valeurs APP et du treillis de codage. Ces valeurs LLR mises à jour constituent une information *a posteriori* notée $\tilde{L}_\ell^\pi$. La valeur extrinsèque $E_\ell(t)$ est obtenue en 869 en lui soustrayant l'information *a priori* :

$$E_\ell(t) = \tilde{L}_\ell^\pi - \left(L_\ell^\pi\right)_e \qquad (22)$$

Cette information extrinsèque représente donc la contribution propre du décodeur à l'estimation des bits d'information. Elle est retardée par un délai 866 correspondant à la période d'itération avant d'être soustraite à l'information *a priori* de l'itération suivante en 862. On rappelle que le fait de soustraire l'information extrinsèque à l'entrée du décodeur permet d'éviter une auto-confirmation des bits par ce dernier.

Enfin, l'information *a posteriori* $\tilde{L}_\ell^\pi$ est désentrelacée dans le module de désentrelacement $\left(\Pi_\ell^I\right)^{-1}$ 868. Cette information *a posteriori* désentrelacée est fournie au décodeur élémentaire de la branche suivante $\ell+1$ comme information *a priori,* étant entendu que la branche suivant celle d'indice $K$-1 est celle d'indice 0. A la première itération, l'information *a priori* est constituée de valeurs de LR nulles (équiprobabilité de 1 et 0). L'état initial et l'état final du treillis sont celui correspondant à une valeur nulle du registre ( $s = 0$ ).

Lorsque le critère d'arrêt est satisfait, une décision dure est prise sur les valeurs de LR pour donner une estimation des bits d'information du bloc.

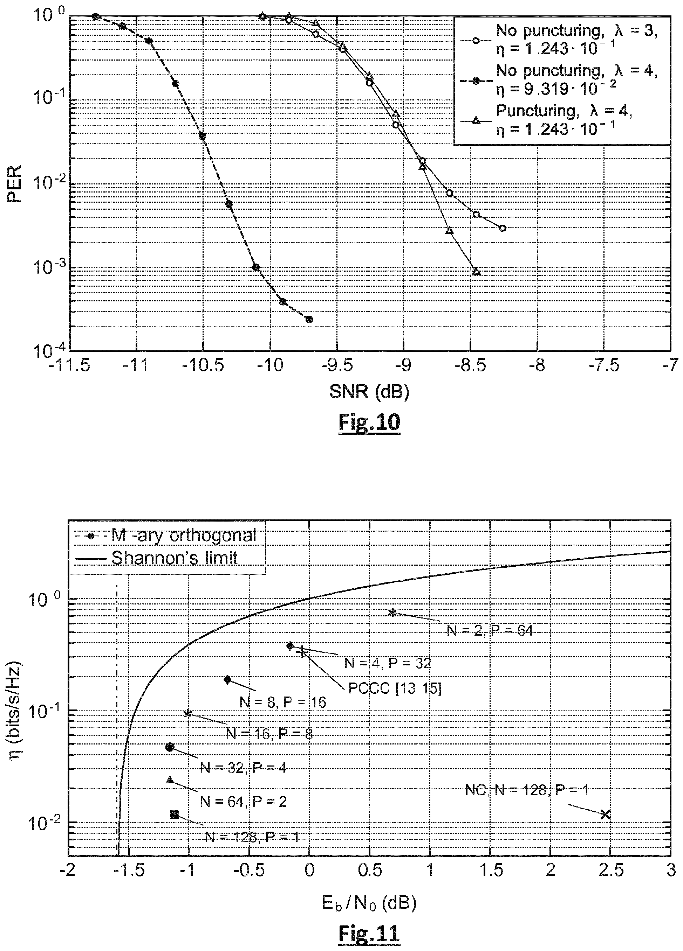

La Fig. 10 donne l'efficacité spectrale en fonction du rapport signal sur bruit pour un système de transmission utilisant un émetteur et un récepteur selon un mode de réalisation de l'invention.

Dans cet exemple, la modulation conjointe est la combinaison d'une modulation orthogonale FSK et d'une modulation linéaire PSK. Ainsi, le nombre $N$ de dimensions orthogonales de l'alphabet est égal au nombre des fréquences et le nombre $P$ de symboles par dimension est égal au nombre de décalages de phase. Sur la figure, on a considéré la taille d'alphabet de modulation conjointe $M = NP$ constante ($M$ = 128) tout en faisant varier la taille $N$ de l'alphabet orthogonal et la taille $P$ de l'alphabet linéaire. La taille $Q$ du bloc est choisie égale à 1000 bits et le nombre $K$ de branches a été pris égal à 4.

On a représenté sur la figure la limite de Shannon $\eta_{sh} = f(E_b / N_0)$ en fonction du rapport signal sur bruit. Les différents points étiquetés par les valeurs de $N$ et $P$ sont les valeurs minimales de rapport signal sur bruit permettant d'effectuer un décodage sans erreur. On a également représenté à titre de comparaison les performances du turbocode LTE (PCCC[13 15]) de l'état de la technique ainsi que celles du schéma Turbo-FSK (modulation orthogonale seule avec $N$ = 128, pas de codage) proposé dans l'article précité. On voit que le système selon l'invention permet de s'approcher de la limite de Shannon sur une large plage de rapport signal sur bruit avec un bon compromis entre efficacité spectrale (distance verticale à la courbe) et efficacité énergétique (distance horizontale à la courbe).

La Fig. 11 donne la courbe de taux d'erreur paquet en fonction du rapport signal sur bruit pour un système de transmission utilisant un émetteur et un récepteur selon un exemple de réalisation de l'invention.

L'exemple illustré correspond à nouveau à une modulation conjointe de taille $M$ = 128, combinaison d'une modulation orthogonale FSK ($N$ = 8) et d'une modulation linéaire PSK ($P$ = 16). On a choisi une taille de bloc $Q$=1000 comme dans les exemples de la Fig. 10.

On a représenté les courbes d'erreurs paquet (PER) en fonction du rapport signal sur bruit (SNR) pour différents nombres de branches ($K$ = 3,$K$ = 4) et différentes stratégies de poinçonnage (poinçonnage $R_{punc}$ = 4/3 pour $K$ = 4, absence de poinçonnage $R_{punc}$ = 1 pour $K$ = 3,$K$ = 4).

On note que l'efficacité spectrale est logiquement identique pour un système à $K$ = 4 branches et un poinçonnage $R_{punc}$ = 4/3 que pour un système à $K$ = 3 branches. Cependant, le plancher du taux d'erreurs paquet PER est inférieur dans le cas du système avec poinçonnage sur 4 branches que dans celui du système sans poinçonnage sur 3 branches.

L'exemple de modulation conjointe selon l'invention, combinant une modulation orthogonale FSK et une modulation linéaire PSK, est particulièrement intéressant dans la mesure où elle est compatible avec une forme d'onde OFDM, proposée pour l'Internet des Objets à bande étroite ou NB-IoT *(Narrow Band IoT),* évolution de la 5G pour les réseaux LPWA et l'IoT.

En outre, cette modulation conjointe offre l'avantage d'un module de signal constant et par conséquent d'un faible facteur de crête ou PAPR *(Peak-to-Average Power Ratio),* ce qui conduit à une faible consommation en énergie de l'émetteur.

**Revendications**

1.  Emetteur destiné à transmettre un bloc de Q bits, ledit émetteur comprenant un turbocodeur (400) recevant ledit bloc et fournissant $K$ mots de code de $m$ bits, le turbocodeur comprenant $K$ branches (410), chaque branche recevant ledit bloc et comprenant un premier entrelaceur (420) destiné à entrelacer les bits du bloc, suivi d'un codeur élémentaire (430) codant chaque mot de $r$ bits en sortie du premier entrelaceur en un mot de code de $m = r + c$ bits où $c$ est un entier non nul, les mots de code fournis par le codeur élémentaire étant entrelacés par un second entrelaceur (440) destiné à entrelacer les mots de code entre eux, le second entrelaceur fournissant les mots de code entrelacés à un poinçonneur (450), l'ensemble des poinçonneurs des différentes branches effectuant un poinçonnage mot des mots de code avec un taux de poinçonnage $R_{punc} > 1$ prédéterminé, le turbocodeur étant suivi d'un modulateur (470) mappant chaque mot de code de m bits en sortie du turbocodeur en un symbole d'un alphabet de modulation $\mathcal{A}$ de taille $M = 2^m$, les symboles de l'alphabet de modulation fournis par le modulateur modulant le signal à émettre, les symboles de l'alphabet de modulation $\mathcal{A}$ étant répartis sur une pluralité $N$ de dimensions orthogonales, les symboles portés par une dimension appartenant à un sous-alphabet linéaire $\mathcal{A}_n$, de taille $P > 1$, avec $M = NP$.

2.  Emetteur selon la revendication 1, **caractérisé en ce que** chaque codeur élémentaire (430) comprend un codeur convolutif (530) de rendement $\dfrac{r+1}{m}$, le codeur élémentaire recevant un mot de $r$ bits, calculant un bit de parité dudit mot (520) et le concaténant à ce dernier pour fournir un mot de $r+1$ bits, le codeur convolutif codant ledit mot de $r+1$ bits en un mot de code de $m$ bits.

3.  Emetteur selon la revendication 1 ou 2, **caractérisé en ce que** les symboles de modulation de l'alphabet de modulation $\mathcal{A}$ sont définis par $x^k = z_p f^n$, $k \in \{0,...,NP-1\}$, où $\mathbf{f}^n = \left( f_0^n, f_1^n, ..., f_{N-1}^n \right)^T$ est un vecteur de taille $N$ représentant un symbole d'un alphabet de modulation orthogonale et $z_p \in \{z_0,...,z_{P-1}\}$ est un symbole d'un alphabet de modulation linéaire.

4.  Emetteur selon la revendication 3, **caractérisé en ce que** l'alphabet de modulation orthogonale est constitué par des symboles de modulation $N - FSK$.

5.  Emetteur selon la revendication 3, **caractérisé en ce que** l'alphabet de modulation orthogonale est constitué par des séquences de Hadamard de taille $N$.

6.  Emetteur selon la revendication 4 ou 5, **caractérisé en ce que** l'alphabet de modulation linéaire est constitué par des symboles $P - PSK$.

7.  Récepteur destiné à recevoir un signal émis par l'émetteur selon la revendication 1, le signal reçu par le récepteur étant démodulé en bande de base pour fournir un bloc de symboles reçus successifs, le récepteur comprenant un convertisseur série parallèle (710) recevant les symboles reçus successifs et les fournissant à une pluralité $K$ de branches parallèles, chaque branche ($\ell$) comprenant un module de détection (730,830) adapté à projeter un symbole reçu ($y^\ell$) sur cette branche sur les $N$ dimensions orthogonales de l'alphabet de modulation $\mathcal{A}$ pour obtenir un vecteur de $N$ composantes ( $Y_0^\ell, Y_1^\ell, ..., Y_{N-1}^\ell$ )et en déduire sous la forme d'un mot de $NP$ valeurs souples le logarithme des probabilités d'observation ( $\log[p(\mathbf{y}^\ell|\mathbf{x}^k)]$ ) du symbole reçu en supposant que les différents symboles de l'alphabet de modulation ont été émis, le module de détection (730) fournissant les mots ainsi obtenus à un module de dépoinçonnage (740,840), le bloc de mots ainsi dépoinçonnés étant désentrelacé dans un module de désentrelacement mot (750, 850) effectuant l'inverse de l'entrelacement mot effectué dans la branche correspondante de l'émetteur avant dêtre fournis à un décodeur élémentaire (760,860), les décodeurs élémentaires des différentes branches étant chaînés entre eux de manière à réaliser un turbodécodage, le turbodécodage fournissant des rapports logarithmiques de probabilité, dits valeurs LR, pour les différents bits d'information du bloc, les bits d'information du bloc étant estimés par décision dure sur les valeurs de LR ainsi obtenues.

**8.** Récepteur selon la revendication 7, **caractérisé en ce que** le module de détection d'une branche $\ell$ calcule les *NP* valeurs souples correspondant à un symbole $\mathbf{y}^\ell$ reçu à partir de $-\dfrac{N}{2\sigma^2}\left|z_p\right|^2 + \dfrac{1}{\sigma^2}\mathrm{Re}\left(Y_n^\ell \overline{z}_p\right)$ , $n=0,..,N-1$, $p=0,..,P-1$, où $Y_n^\ell$ est la composante du symbole reçu, $\mathbf{y}^\ell$, sur la n$^\text{ième}$ dimension de l'alphabet de modulation, $z_p$ est un symbole de modulation linéaire porté par la n$^\text{ième}$ dimension de l'alphabet de modulation, $\overline{z}_p$ est le conjugué de $z_p$, et $\sigma^2$ est la puissance de bruit reçu.

**9.** Récepteur selon la revendication 8, **caractérisé en ce que** la modulation orthogonale est une modulation FSK et que les composantes $Y_n^\ell$ du symbole reçu $\mathbf{y}^\ell$ sont obtenues en corrélant le symbole reçu avec les différentes lignes d'une matrice DFT de taille $N \times N$.

**10.** Récepteur selon la revendication 8, **caractérisé en ce que** la modulation orthogonale est une modulation de Hadamard et que les composantes $Y_n^\ell$ du symbole reçu $\mathbf{y}^\ell$ sont obtenues en corrélant le symbole reçu avec les différentes lignes d'une matrice de Hadamard de taille $N \times N$.

**11.** Récepteur selon la revendication 8, **caractérisé en ce que** le décodeur élémentaire d'une branche $\ell$ comprend un bloc de sommation (865) effectuant la somme des *NP* valeurs souples $-\dfrac{N}{2\sigma^2}\left|z_p\right|^2 + \dfrac{1}{\sigma^2}\mathrm{Re}\left(Y_n^\ell \overline{z}_p\right)$ , $n=0,..,N-1$, $p=0,..,P-1$, d'un mot et d'une information *a priori* fournie sur les symboles de modulation représentant la probabilité *a priori* que les différents symboles de modulation aient été émis, pour donner une information *a posteriori* représentant la probabilité que les différents symboles de modulation aient été émis compte tenu de l'observation du symbole $\mathbf{y}^\ell$ reçu par la branche $\ell$.

**12.** Récepteur selon la revendication 11, **caractérisé en ce que** l'information *a priori* sur les symboles de modulation est obtenue par un module de conversion (863) à partir d'une information *a priori* sur les bits d'information fournie par la branche $\ell$-1.

**13.** Récepteur selon la revendication 12, **caractérisé en ce que** le décodeur élémentaire d'une branche $\ell$ comprend en outre un module de décodage BCJR utilisant le treillis de codage du codeur élémentaire correspondant de l'émetteur pour déterminer, à partir de l'information *a posteriori* sur les différents symboles, une information *a posteriori* sur les différents bits d'information représentant la probabilité *a posteriori* desdits différents bits d'information.

**14.** Récepteur selon la revendication 12, **caractérisé en ce que** l'information *a priori* sur les différents bits d'information fournie par la branche $\ell$-1 est soustraite (869) à l'information *a posteriori* sur les différents bits d'information pour déterminer une information extrinsèque, ladite information extrinsèque étant soustraite (862) à une itération suivante de l'information *a priori* sur les différents bits d'information à l'entrée du module de conversion (863).

**Patentansprüche**

**1.** Sender zum Senden eines Blocks von *Q* Bits, wobei der Sender einen Turbocodierer (400) aufweist, der den Block empfängt und *K* Codewörter von *m* Bits bereitstellt, wobei der Turbocodierer *K* Zweige (410) aufweist, wobei jeder Zweig den Block empfängt und einen ersten Interlacer (420) zum Verschachteln der Bits des Blocks aufweist, gefolgt von einem Elementarcodierer (430), der jedes Wort mit *r* Bits am Ausgang des ersten Interlacers in ein Codewort mit $m = r + c$ Bits codiert, wobei *c* eine ganze Zahl ungleich Null ist, wobei die von dem elementaren Codierer gelieferten Codewörter durch einen zweiten Interlacer (440) verschachtelt werden, der dazu bestimmt ist, die Codewörter miteinander zu verschachteln, wobei der zweite Interlacer die verschachtelten Codewörter an einen Puncher (450) liefert, wobei alle Puncher der verschiedenen Zweige ein Wort-Punching der Codewörter mit einer vorbestimmten Punchingrate $R_{punc} > 1$ durchführen, wobei dem Turbocodierer ein Modulator (470) folgt, der jedes *m*-Bit-Codewort am Ausgang des Turbocodierers in ein Symbol eines Modulationsalphabets $\mathcal{A}$ der Größe $M = 2^m$

abbildet, wobei die vom Modulator gelieferten Symbole des Modulationsalphabets das zu sendende Signal modulieren, wobei die Symbole des Modulationsalphabets $\mathcal{A}$ über eine Vielzahl $N$ orthogonaler Dimensionen verteilt sind, wobei die von einer Dimension getragenen Symbole zu einem linearen Subalphabet $\mathcal{A}_n$ der Größe $P > 1$ mit $M = NP.$ gehören.

2. Sender nach Anspruch 1, **dadurch gekennzeichnet, dass** jeder Elementarcodierer (430) einen Faltungscodierer (530) mit einer Effizienz von $\frac{r+1}{m}$ aufweist, wobei der Elementarcodierer ein $r$-Bit-Wort empfängt, ein Paritätsbit des Wortes (520) berechnet und es mit diesem verkettet, um ein Wort von $r+1$ Bits zu liefern, wobei der Faltungscodierer das Wort von $r+1$ Bits in ein Codewort von $m$ Bits codiert.

3. Sender nach Anspruch 1 oder 2, **dadurch gekennzeichnet, dass** die Modulationssymbole des Modulationsalphabets $\mathcal{A}$ durch $x^k = z_p f^n$, $k \in \{0,..., NP\text{-}1\}$ definiert sind, wobei $\mathbf{f}^n = \left( f_0^n, f_1^n, ..., f_{N-1}^n \right)^T$ ein Vektor der Größe N ist, der ein Symbol eines orthogonalen Modulationsalphabets darstellt, und $z_p \in \{z_0, ..., z_{P\text{-}1}\}$ ein Symbol eines linearen Modulationsalphabets ist.

4. Sender nach Anspruch 3, **dadurch gekennzeichnet, dass** das orthogonale Modulationsalphabet aus $N$ - FSK -Modulationssymbolen besteht.

5. Sender nach Anspruch 3, **dadurch gekennzeichnet, dass** das orthogonale Modulationsalphabet aus Hadamard-Sequenzen der Größe $N$ besteht.

6. Sender nach Anspruch 4 oder 5, **dadurch gekennzeichnet, dass** das lineare Modulationsalphabet aus $P$ - PSK -Symbolen besteht.

7. Empfänger zum Empfangen eines vom Sender gesendeten Signals nach Anspruch 1, wobei das vom Empfänger empfangene Signal im Basisband demoduliert wird, um einen Block aufeinanderfolgender empfangener Symbole bereitzustellen, wobei der Empfänger einen seriellen Parallelwandler (710) aufweist, der die aufeinanderfolgenden empfangenen Symbole empfängt und sie an eine Vielzahl $K$ von parallelen Zweigen ausgibt, wobei jeder Zweig ($\ell$) ein Detektionsmodul (730, 830) aufweist, das dazu ausgebildet ist, ein empfangenes Symbol ($\mathbf{y}^\ell$) auf diesem Zweig auf die $N$ orthogonalen Dimensionen des Modulationsalphabets $\mathcal{A}$ zu projizieren, um einen Vektor von $N$ Komponenten ( $Y_0^\ell, Y_1^\ell, ..., Y_{N-1}^\ell$ ) und daraus in Form eines Wortes mit $NP$ weichen Werten den Logarithmus der Beobachtungswahrscheinlichkeiten ($\log[p(\mathbf{y}^\ell | \mathbf{x}^k)]$) des empfangenen Symbols unter der Annahme, dass die verschiedenen Symbole des Modulationsalphabets gesendet wurden, abzuleiten, wobei das Detektionsmodul (730) die so erhaltenen Wörter an ein Entschachtelungsmodul (740, 840) liefert, wobei der Block der so entschachtelten Wörter in einem Wortentschachtelungsmodul (750, 850) entschachtelt wird, das die Umkehrung der im entsprechenden Zweig des Senders durchgeführten Wortverschachtelung vornimmt, bevor sie einem Elementardecoder (760, 860) zugeführt werden, wobei die Elementardecoder der verschiedenen Zweige derart miteinander verkettet sind, dass sie eine Turbodecodierung durchführen, wobei die Turbodecodierung logarithmische Wahrscheinlichkeitsverhältnisse, die sogenannten LR-Werte, für die verschiedenen Informationsbits des Blocks liefert, wobei die Informationsbits des Blocks durch harte Entscheidung über die so erhaltenen LR-Werte geschätzt werden.

8. Empfänger nach Anspruch 7, **dadurch gekennzeichnet, dass** das Modul zur Erkennung eines Zweiges $\ell$ die $NP$ zulässigen Werte berechnet, die einem empfangenen Symbol $\mathbf{y}^\ell$ entsprechen, aus $-\dfrac{N}{2\sigma^2}\left|z_p\right|^2 + \dfrac{1}{\sigma^2}\mathrm{Re}\left(Y_n^\ell \overline{z}_p\right)$ , $n=0,..,N$ -1, $p = 0,..,P$ -1, wobei $Y_n^\ell$ die Komponente des empfangenen Symbols ist, $\mathbf{y}^\ell$ auf der n-ten Dimension des Modulationsalphabets, $z_p$ ein lineares Modulationssymbol, das von der n-ten Dimension des Modulationsalphabets getragen wird, $\overline{z}_p$ die Konjugierte von $z_p$ und $\sigma^2$ die Leistung des empfangenen Rauschens ist.

9. Empfänger nach Anspruch 8, **dadurch gekennzeichnet, dass** die orthogonale Modulation eine FSK-Modulation ist und dass die Komponenten $Y_n^\ell$ des empfangenen Symbols $\mathbf{y}^\ell$ durch Korrelation des empfangenen Symbols mit den verschiedenen Zeilen einer DFT-Matrix der Größe $N \times N$ erhalten werden.

10. Empfänger nach Anspruch 8, **dadurch gekennzeichnet, dass** die orthogonale Modulation eine Hadamard-Modulation ist und dass die Komponenten $Y_n^\ell$ des empfangenen Symbols $\mathbf{y}^\ell$ durch Korrelieren des empfangenen Symbols mit den verschiedenen Zeilen einer Hadamard-Matrix der Größe $N \times N$ erhalten werden.

11. Empfänger nach Anspruch 8, **dadurch gekennzeichnet, dass** der Elementardecoder eines Zweigs $\ell$ einen Summationsblock (865) aufweist, der die Summe der *NP* zulässigen Werte $-\dfrac{N}{2\sigma^2}\left|z_p\right|^2 + \dfrac{1}{\sigma^2}\mathrm{Re}\left(Y_n^\ell \overline{z}_p\right)$ , $n = 0,..,N$ *-1, p = 0, ..,P -1,* eines Wortes und einer über die Modulationssymbole gelieferten A-priori-Information, die die A-priori-Wahrscheinlichkeit darstellt, dass die verschiedenen Modulationssymbole gesendet wurden, bildet, um eine A-posteriori-Information zu liefern, die die Wahrscheinlichkeit darstellt, dass die verschiedenen Modulationssymbole unter Berücksichtigung der Beobachtung des von dem Zweig $\ell$ empfangenen Symbols $\mathbf{y}^\ell$ gesendet wurden.

12. Empfänger nach Anspruch 11, **dadurch gekennzeichnet, dass** die A-priori-Information über die Modulationssymbole von einem Konvertierungsmodul (863) aus einer A-priori-Information über die Informationsbits gewonnen wird, die von dem Zweig $\ell$-1- geliefert wird.

13. Empfänger nach Anspruch 12, **dadurch gekennzeichnet, dass** der Elementarcodierer eines Zweiges $\ell$ zusätzlich ein BCJR-Decodiermodul aufweist, das den Codiergitterbaum des entsprechenden Elementarcodierers des Senders verwendet, um aus der a posteriori Information über die verschiedenen Symbole eine a posteriori Information über die verschiedenen Informationsbits zu bestimmen, die die a posteriori Wahrscheinlichkeit der verschiedenen Informationsbits darstellt.

14. Empfänger nach Anspruch 12, **dadurch gekennzeichnet, dass** die von Zweig $\ell$-1 gelieferte A-priori-Information über die verschiedenen Informationsbits von der A-posteriori-Information über die verschiedenen Informationsbits subtrahiert (869) wird, um eine extrinsische Information zu bestimmen, wobei die extrinsische Information bei einer nächsten Iteration der A-priori-Information über die verschiedenen Informationsbits am Eingang des Umwandlungsmoduls (863) subtrahiert (862) wird.

**Claims**

1. A transmitter for transmitting a block of Q bits, said transmitter comprising a turbocoder (400) receiving said block and providing *K* code words having *m* bits, the turbocoder comprising *K* branches (410), each branch receiving said block and comprising a first interleaver (420) for interleaving the bits of the block, followed by an elementary coder (430) coding each word having r bits at the output of the first interleaver into a code word having *m = r + c* bits where c is a non-null integer, the code words provided by the elementary coder being interleaved by a second interleaver (440) for interleaving the code words together the second interleaver providing the interleaved code words to a puncturer (450), all the puncturers of the different branches performing a word puncturing of the code words with a predetermined puncturing rate $R_{punc} > 1$ the turbocoder being followed by a modulator (470) mapping each code word having m bits at the output of the turbocoder into a symbol of a modulation alphabet $\mathcal{A}$ having a size $M = 2^m$, the symbols of the modulation alphabet provided by the modulator modulating the signal to be transmitted, the symbols of the modulation alphabet $\mathcal{A}$ being distributed on a plurality *N* of orthogonal dimensions, the symbols carried by a dimension belonging to a linear sub-alphabet $\mathcal{A}_n$ , having a size *P > 1*, with *M = NP* .

2. The transmitter according to claim 1, **characterised in that** each elementary coder (430) comprises a convolutional coder (530) with a rate $\dfrac{r+1}{m}$ , the elementary coder receiving a word with *r* bits, calculating a parity bit of said word (520) and concatenating it to the same to provide a word with $r$+1 bits, the convolutional coder coding said word having $r$+1 bits into a code word having $m$ bits.

3. The transmitter according to claim 1 or 2, **characterised in that** the modulation symbols of the modulation alphabet $\mathcal{A}$ are defined by $x^k = z_p f^n$, $k \in \{0,...,NP$ -1$\}$ , where $\mathbf{f}^n = \left( f_0^n, f_1^n, ..., f_{N-1}^n \right)^T$ is a vector having a size $N$ representing a symbol of an orthogonal modulation alphabet and $z_p \in \{z_0,...,z_{P-1}\}$ is a symbol of a linear modulation alphabet.

4. The transmitter according to claim 3, **characterised in that** the orthogonal modulation alphabet consists of modulation symbols $N$ - $FSK$.

5. The transmitter according to claim 3, **characterised in that** the orthogonal modulation alphabet consists of Hadamard sequences having a size $N$.

6. The transmitter according to claim 4 or 5, **characterised in that** the linear modulation alphabet consists of symbols $P$ - $PSK$.

7. A receiver for receiving a signal transmitted by the transmitter according to claim 1, the signal received by the receiver being base-band demodulated to provide a block of successive received symbols, the receiver comprising a series-parallel converter (710) receiving the successive received symbols and providing them to a plurality $K$ of parallel branches, each branch ($\ell$) comprising a detection module (730, 830) adapted to project a symbol ($\mathbf{y}^\ell$) received on this branch onto the $N$ orthogonal dimensions of the modulation alphabet $\mathcal{A}$ to obtain a vector having $N$ components ( $Y_0^\ell, Y_1^\ell, ..., Y_{N-1}^\ell$ ) and deduce therefrom as a word having $NP$ soft values the logarithm of the observation probabilities ( $\log[p(\mathbf{y}^\ell|\mathbf{x}^k)]$ ) of the received symbol assuming that the different symbols of the modulation alphabet have been transmitted, the detection module (730) providing the words thus obtained to a depuncturing module (740, 840), the block of words thus depunctured being deinterleaved in a word deinterleaving module (750, 850) performing the inverse of the word interleaving performed in the corresponding branch of the transmitter before being provided to an elementary decoder (760, 860), the elementary decoders of the different branches being chained together so as to perform turbodecoding, the turbodecoding providing probability logarithmic ratios, called LR values, for the different information bits of the block, the information bits of the block being estimated by a hard decision on the LR values thus obtained.

8. The receiver according to claim 7, **characterised in that** the detection module of a branch $\ell$ calculates the $NP$ soft values corresponding to a symbol $\mathbf{y}^\ell$ received from $-\dfrac{N}{2\sigma^2}\left| z_p \right|^2 + \dfrac{1}{\sigma^2}\mathrm{Re}\left( Y_n^\ell \overline{z}_p \right)$ , $n$ = 0,.., $N$-1, $p$ = 0,..,$P$ -1, where $Y_n^\ell$ is the component of the received symbol $\mathbf{y}^\ell$, on the n$^{\text{th}}$ dimension of the modulation alphabet, $z_p$ is a linear modulation symbol carried by the n$^{\text{th}}$ dimension of the modulation alphabet, $\overline{z}_p$ is the conjugate of $z_p$, and $\sigma^2$ is the power of received noise.

9. The receiver according to claim 8, **characterised in that** the orthogonal modulation is a FSK modulation and **in that** the components $Y_n^\ell$ of the received symbol $\mathbf{y}^\ell$ are obtained by correlating the received symbol with the different rows of a DFT matrix having a size $N \times N$.

10. The receiver according to claim 8, **characterised in that** the orthogonal modulation is a Hadamard modulation and **in that** the components $Y_n^\ell$ of the received symbol $\mathbf{y}^\ell$ are obtained by correlating the received symbol with the different rows of a Hadamard matrix having a size $N \times N$.

11. The receiver according to claim 8, **characterised in that** the elementary decoder of a branch $\ell$ comprises a summing

block (865) performing the sum of the *NP* soft values $-\dfrac{N}{2\sigma^2}\left|z_p\right|^2 + \dfrac{1}{\sigma^2}\mathrm{Re}\left(Y_n^\ell \overline{z}_p\right)$ , $n = 0,..,\ N -1,\ p = 0,..,\ P -1,$ of a word and of an *a priori* piece of information provided on the modulation symbols representing the *a priori* probability that the different modulation symbols have been transmitted, to give an *a posteriori* piece of information representing the probability that the different modulation symbols have been transmitted in view of the observation of the symbol $y^\ell$ received by the branch $\ell$.

**12.** The receiver according to claim 11, **characterised in that** the *a priori* piece of information on the modulation symbols is obtained by a conversion module (863) from an *a priori* piece of information on the information bits provided by the branch $\ell$-1.

**13.** The receiver according to claim 12, **characterised in that** the elementary decoder of a branch $\ell$ further comprises a BCJR decoding module using the coding trellis of the elementary coder corresponding to the transmitter to determine, from the *a posteriori* piece of information on the different symbols, an *a posteriori* piece of information on the different information bits representing the *a posteriori* probability of said different information bits.

**14.** The receiver according to claim 12, **characterised in that** the *a priori* piece of information on the different information bits provided by the branch $\ell$-1 is subtracted (869) from the *a posteriori* piece of information on the different information bits to determine an extrinsic piece of information, said extrinsic piece of information being subtracted (862) from a following iteration of the *a priori* piece of information on the different information bits at the input of the conversion module (863).

**Fig. 1**

**Fig. 2**

$$N = 4$$

$$P = 4$$

**Fig. 3**

**Fig. 4**

510

530

$r$ bits

conv.
coder

$$\frac{r+1}{m}$$

520

**Fig. 5**

taux de poinçonnage =4/3

K= 4 branches

● Emitted
○ Punctured

Symbol index

**Fig. 6**

**Fig. 7**

$x^8\ x^{11}\ x^{13}\ x^{14}$

$s = 0$ ... $s = 0$

$x^1$
$x^2$
$x^4$
$x^7$

$x^9$
$x^{10}$
$x^{12}$
$x^{15}$

$s = 1$ ... $s = 1$

$x^0\ x^3\ x^5\ x^6$

$n$ ... $n+1$

**Fig. 9**

**Fig. 8**

**Fig.10**

**Fig.11**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description

- **L. PING et al.** Low rate turbo-Hadamard codes. *IEEE Trans. on Information Theory,* Décembre 2003, vol. 49 (12), 3213-3224
- **Y. ROTH et al.** Turbo-FSK : a new uplink scheme for Low Power Wide Area Network. *Proc. of the IEEE 16th Int'l Workshop on Signal Processing Advances in Wireless Communications (SPAWC),* Juin 2015, 81-85
- **ROTH YOANN et al.** Turbo-FSK : a new uplink scheme for low power wide area networks. *Proc. of 2015 IEEE 16th International Workshop on Signal Processing Advances in Wireless Communications (SPAWC),* 28 Juin 2015, 81-85
- **RUI ALVES.** Coding of PPM based modulation techniques to improve the performance of infrared WLANs. *IEEE Vehicular Technology Conference, VTC,* 24 Septembre 2000, vol. 3, 1345-1352
- A novel trellis coded overlapping amplitude and pulse position modulation scheme for gamma-gamma channel free-space optical communication. **WANG KAIMIN et al.** China Communications. China Institute of Communications, 01 Avril 2016, vol. 13, 58-69